# EUROPEAN PATENT APPLICATION

(11) **EP 2 284 738 A1**
(43) Date of publication of application: **16.02.2011**
(21) Application number: 09167789.8
(22) Date of filing: 13.08.2009
(51) Int. Cl.: G06F 17/50

(54) **Integration of functional CAE data in the CAD based design process for industrial design, esp. cars, motorbikes or aeronautic vehicles**

(71) Applicant: Honda Research Institute Europe GmbH, 63073 Offenbach/Main (DE)
(72) Inventor: Sendhoff, Bernhard, Prof. Dr., 63486 Bruchköbel (DE); Olhofer, Markus, Dr., 64832 Babenhausen (DE)
(74) Representative: Rupp, Christian

(57) **Abstract**

The invention proposes computer-assisted systems and methods for designing real-world objects, such as automobiles, by integrating aesthetic and functional design processes.
The system comprises:
a.) a computerized module for defining an aesthetic representation of a real-world object,
b.) a computing module supplied with approximation model data of a CAE simulation module to calculate functional quality value(s) using a parametric description of the aesthetic representation as input,
c.) an interface for issuing a physical signal to a user, the physical signal communicating the quality value(s) to the user, and
d.) a computerized module for changing the parametric description of the aesthetic representation of the object in the aesthetic design process taking the obtained functional quality value into account.

## Description

### Background of the invention:

In industrial design, e.g. automotive design, the aesthetic styling (aesthetic design) has to be coupled with functional requirements (functional design) and performance measures from CAE (Computer Aided Engineering) systems, e.g. dynamic stability, aerodynamics, computational fluid dynamics (CFD), structural stability, etc. In the overall design process, functional constraints are often used to define the initial conceptual design which is then shaped by the designer according to some aesthetic requirements, e.g. based on the designer's artistic taste and/or on the overall brand design requirements. Traditionally, the aesthetic design phase involves clay models, which are nowadays augmented by CAD models, interactive immersive displays [1] and virtual clay systems [2]. After the aesthetic design phase, again functional requirements can alter the final design and shape.

However, both processes (aesthetic and functional design) are largely decoupled and handled by different groups of people (i.e. designers and engineers).

In general, the representations, i.e. the parametric descriptions of objects, are different for the aesthetic design process and the functional design process.

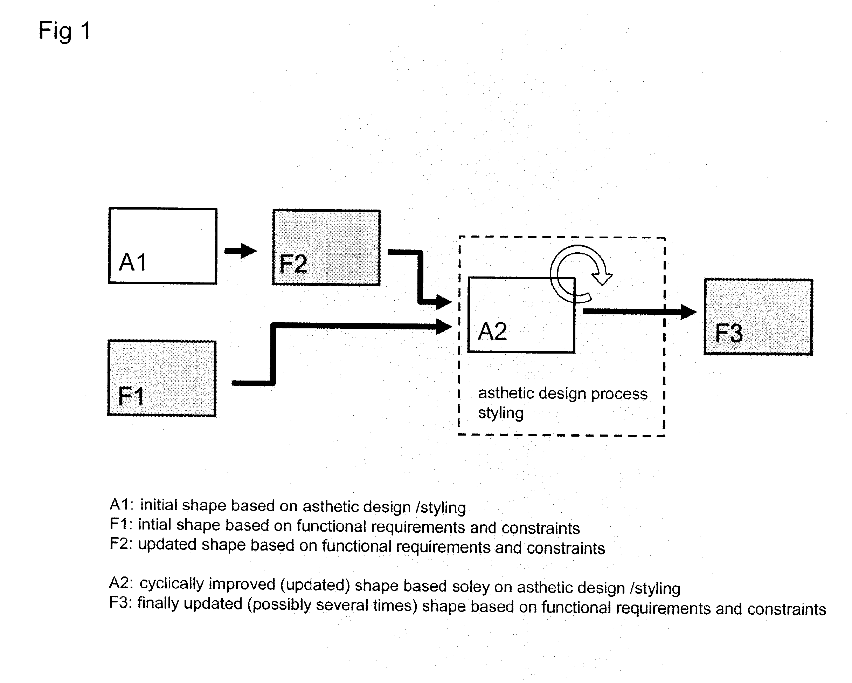

Figure 1 schematically shows this known approach, wherein steps F1-F3 are optional.

### State of the art:

The use of surrogate or meta-models has been suggested previously in the context of design optimization without any aesthetic design phase (see e.g. [4,5,6]).

However, as will be explained later in greater detail, in the framework put forward in this patent surrogate models are embedded into the aesthetic design phase in order to enable a tight coupling between aesthetic design and functional design.

### Object of the invention:

It is the object of the invention to propose a process that allows a tight coupling between the aesthetic and the functional design processes, thereby achieving an efficient and comprehensive approach for designing real-world objects which at the same time meet physical and aesthetic requirements. E.g. when designing cars, motorbikes and planes using the invention, the physical requirements can be e.g. minimizing weight and/or drag.

Thus the invention also allows the manufacturing of aesthetic real-world objects, which also satisfy functional criteria, which functional criteria can be expressed in terms of physical entities.

This object is achieved by means of the features of the independent claims. The dependent claims develop further the central idea of the present invention.

A first aspect of the invention relates to a method for providing designers direct feedback on the functional quality of their current aesthetic design of real-world objects, thus improving the design process and facilitating the manufacturing of aesthetic and functional real-world object.

The method comprising the following steps:
a.) a representation (i.e. a parametric description) of an object from the aesthetic design process (e.g. CAD data) is given,
b.) from the given representation a quality value is derived (computed by a artificial computing unit) based on physical requirements of the functional design process
c.) a (e.g. haptic, visual or acoustical) physical signal is issued to a user, the physical signal communicating the quality value to the user,
d.) the object is changed resulting in different parameters of the representation according to the aesthetic requirements of the designer taking the functional quality value into account
e.) steps b.) to d.) are repeated until a termination criterion is met.

The invention also proposes a method comprising the following steps:
a.) a representation (i.e. a parametric description) of an object from the aesthetic design process (e.g. CAD data) is given,
b.) from the given representation a quality value is derived based on the physical requirements of the functional design process,
c.) a computational optimization process is invoked where the object is slightly altered as to minimize / maximize the quality value which is derived based on the physical requirements of the functional design process,
c.) a physical signal is issued to a user, the physical signal communicating to a user as how to modify the design in order to achieve an improved quality value, or the physical signal communicating to the user at least one alternative design having an improved quality value,
d.) the object is changed resulting in different parameters of the representation according to the aesthetic requirements of the designer taking the functional quality value into account,
e.) steps b.) to d.) are repeated until a termination criterion is met.

The method may comprise the additional step of:
f.) building the real world object based on the representation (i.e. parametric description) of the object present when the termination criterion has been met.

The aesthetic representation of the design may be based on CAD data, while the optimization process will be performed based on a different functional representation, e.g. free form deformation [8] or NURBS [7].

The derivation of the functional quality of the aesthetic design which is required in the first process as well as in the second process including the additional optimization loop has to be very fast so that the designer receives direct and real-time feedback of the functional quality of the object (besides his own aesthetic judgment). Current CAE methods do not allow this fast feedback, therefore, models have to be employed, which represent a functional approximation of the CAE calculations. Examples of such models (which have been termed surrogates or meta-models or surrogate models in the context of functional design optimization [4]) are neural networks, Kriging (Gaussian) models, response surface models, polynomial models. Based on available CAE data that has been generated prior to the aesthetic design process (and which can also constantly be updated during the aesthetic design process), the model is generated using methods from e.g. neural network learning or mathematical statistics. Such models can then replace the costly CAE calculations. The models are very fast and can be used in real-time in direct interaction with the designer. The models can directly receive the aesthetic object representation, e.g. CAD data, as input or use their own model-dependent representation. In the latter case, a transformation has to be included from the aesthetic representation to the model representation.

Step d.) may be done in order to change the aesthetic appearance of the design.

The physical signal may be a visual indication and/or a haptic feedback.

The invention also relates to computer software program product, implementing a method according to any of the preceding claims when run on a computing device.

The invention furthermore relates to a computer-assisted system for designing real-world objects, the system comprising the following steps:
a.) a module for providing a representation (i.e. a parametric description) of an object from the aesthetic design process (e.g. CAD data)
b.) a module for deriving a quality value from the given representation based on the physical requirements of the functional design process
c.) an interface for issuing a physical signal to a user, the physical signal communicating the quality value to the user,
d.) a modification interface for changing the object resulting in different parameters of the representation according to the aesthetic requirements of the designer taking the functional quality value into account

Finally the invention relates to a computer-assisted system for designing real-world objects,
the system comprising:
a.) a module for providing a representation (i.e. a parametric description) of an object from the aesthetic design process (e.g. CAD data)
b.) a module for deriving a quality value from the given representation based on the physical requirements of the functional design process
c.) a module for executing a computational optimization process where the object is slightly altered as to minimize / maximize the quality value which is derived based on the physical requirements of the functional design process
c.) an interface for issuing a physical signal to a user, the physical signal communicating to a user as how to modify the design in order to achieve an improved quality value, or the physical signal communicating to the user at least one alternative design having an improved quality value, and
d.) a modification user interface for changing the object resulting in different parameters of the representation according to the aesthetic requirements of the designer taking the functional quality value into account.

Further features, objects and advantages of the invention will become evident when reading the following detailed description of an embodiment, taken in conjunction with the figures of the enclosed drawings.
- Figure 1: is a general view of the modules of a known design system.
- Figure 2a: is a general view of the modules of a first embodiment of a design system according to the invention where only a functional quality value is communicated to the user.
- Figure 2b: is a modification of the system of figure 2a where an additional optimization loop is executed and alternative designs or design directions are communicated to the user.
- Figure 2c: shows details of the optimization module P1 of Figures 2b.
- Figure 3: shows the training of the model (targeting the correct functional approximation) with apriori available functional data. This is used in conjunction with the processes depicted in Figure 2a and 2b.
- Figure 4: shows the additional training of the model (targeting the correct functional approximation) with data generated during the design process. This is used in conjunction with the processes depicted in Figure 2a and 2b.

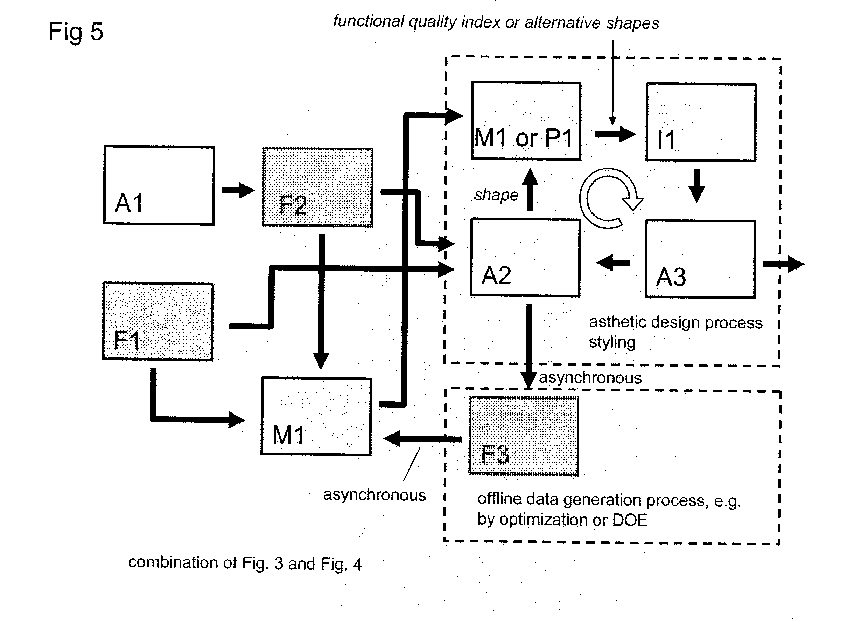

- Figure 5: shows the combination of apriori and online training of the model (Fig. 3 and Fig. 4).
- Figure 6a to 6c: show examples of interfacing results of the functional quality estimation and/or functional optimization back to the user. 6a: displaying a quality index of an aesthetic design, 6b: colour encoding of favourable and unfavourable (according to the functional quality values) directions for the aesthetic design process, 6c: haptic encoding of favourable and unfavourable (according to the functional quality values) directions for the aesthetic design process.

To summarize, the invention proposes to at least partially merge the computer based (CAD, immersive interactive displays, virtual clay systems) aesthetic design phase with the functional design process e.g. from CAE systems. This makes the overall process more efficient, the aesthetic process more comprehensive, i.e. no changes are made to the styling after the aesthetic design process has been completed, and the integration of functional requirements easier and as a result more comprehensive. In order to allow such a tight integration of both processes and therefore to realize the described advantages, mainly two problems have to be solved. Firstly, the computation time required for the CAE analysis (e.g. aerodynamic parameters with computational fluid dynamics CFD, or dynamic stability) does not allow the online calculation of CAE based functional performance indices during the aesthetic based design process, i.e. while the stylist is constantly changing the shape of a design (e.g. an automotive), it is not possible to continuously calculate the quality indices for every shape. Secondly, if the performance indices for each shape are available (i.e. question one is solved), how can this information be conveyed to the stylist in a way that s/he (who does not necessarily have a strong technological background) can use this information most efficiently.

### Detail of the invention:

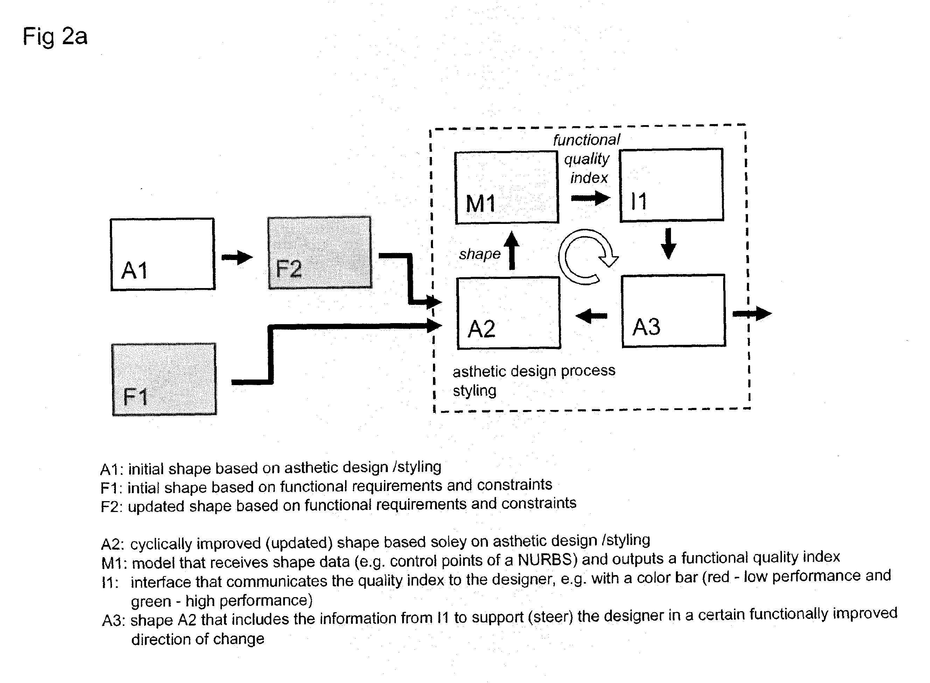

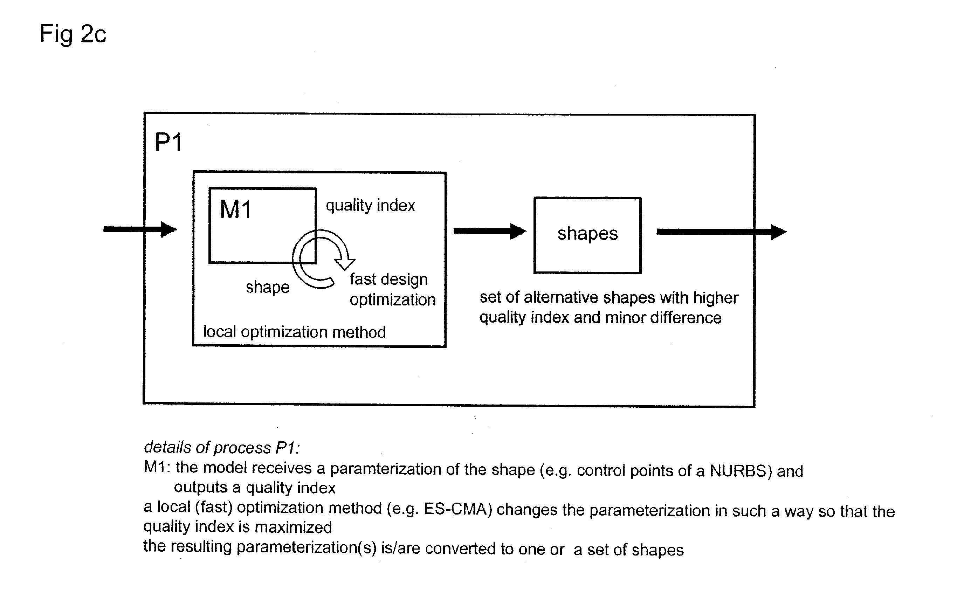

The problems formulated in the above section are solved in the following ways. In order to circumvent the time constraint, a model M1 will be used during the aesthetic design process instead of the true CAE calculations. This model serves a similar purpose as surrogate models during traditional design optimization. A variety of different model structures are conceivable, examples are neural networks, response surface models, polynomial models, Kriging (Gaussian) models. These models approximate the function of the CAE calculations. Since the model response time is very fast it can be used during the design process as an immediate feedback to the designer on the current shape as shown in Figure 2a.

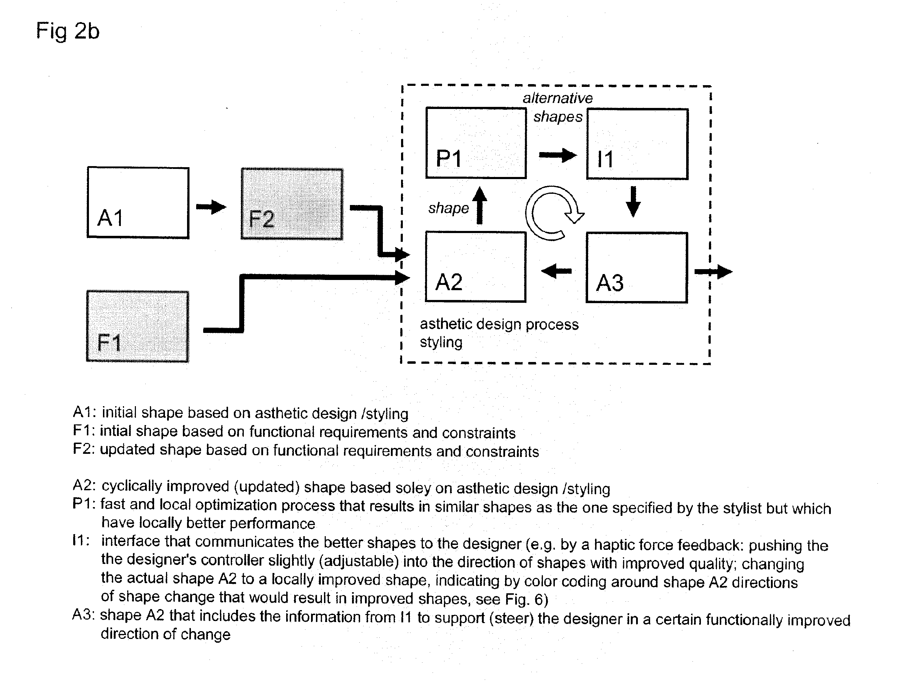

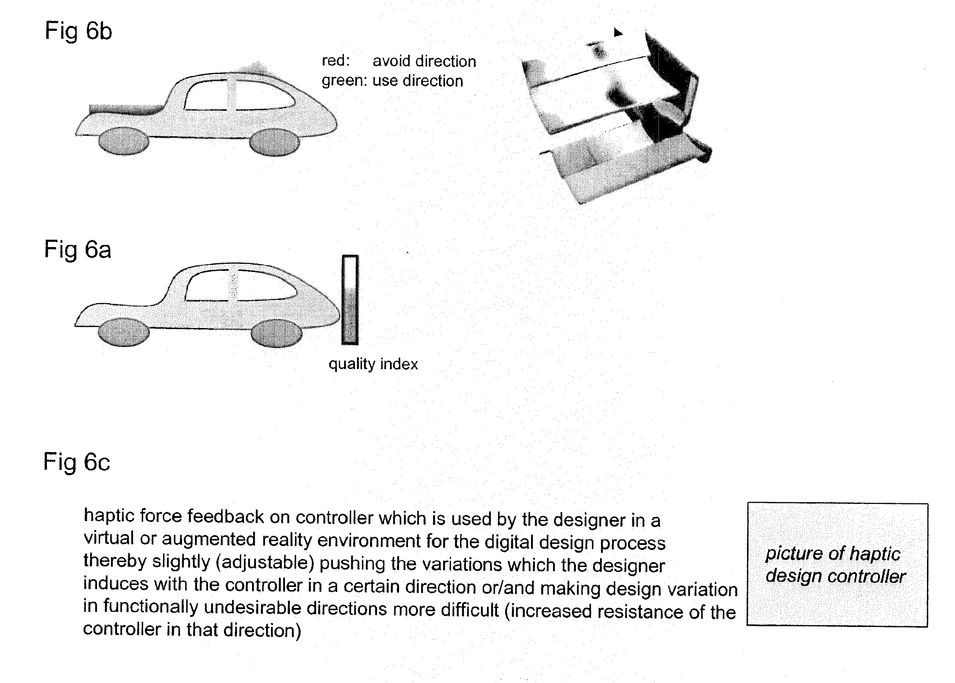

Additionally, a fast optimization process can be carried out using the model as a quality measure (denoted by process P1 in Figure 2b), which would not only provide a quality feedback on the current shape to the designer, but also alternative similar shapes with a better functional quality (i.e. with respect to CAE calculations like CFD) and information on the sensitivity of the current shape with respect to future changes (e.g. encoded by the interface specified in Fig 6b).

In general, different representations of the object (i.e. its parametric description) will be used for the aesthetic design process, for the functional design process and for the model. When merging the different processes, interfaces between those representations are necessary. Representations suitable for the aesthetic design processes are usually determined by the computational tools used by the designers, a standard tool and the associate representations are CAD data. The functional representations have to be low dimensional and have to be suitable for computational changes of the design in the context of CAE systems like fluid dynamics. Since most CAE systems rely on a computational grid or mesh for the calculations, functional representations must either be able to adapt the computational grid of the CAE solver or they must be suitable for automatically generating new grids/meshes during the functional design process based on the current functional representation. NURBS [7] and free form deformation [8] representations have been shown to be very suitable functional representations. Model representations are usually low dimensional functional representations. Universal representations like STL representations [9] can be employed in order to switch between the three types of representations.

Therefore, in a typical embodiment of the invention, the model receives a parameterization of the shape as input, e.g. the control points of a NURBS representation or a Free Form Deformation representation, see e.g. [7, 8] or alternatively CAD representations. The output of the model would be a quality index/value or several quality indices/values that are used to functionally characterize the design (e.g. drag coefficients for aerodynamic optimization of automotive chassis).

The second problem on how to convey the information back to the designer can be solved in different ways. In the case of Figure 2a, i.e. when a quality value for the current design is calculated this can be displayed e.g. visually to the designer, e.g. using a color code (red: bad, green: good performance or a performance column (meter) as shown in Figure 6a, where the height corresponds to the quality. In the case of Figure 2b, where alternative shapes are available, more sophisticated interfaces are proposed.

Firstly, promising directions can be calculated from the current shape and the shapes produced by the optimization process P1, these directions can be color coded and displayed behind (left figure) or on (right figure) the current design (Fig. 6b), e.g. changes normal to the shape where the design is red are to be avoided and where the design is green (or blue) changes normal to the current shape are likely to increase the functional performance. Furthermore, the shape information can be communicated back to the designer in more subtle ways as described in Figure 6c. Haptic force feedback on the controller which is used by the designer in a virtual or augmented reality environment for the digital design process is used as an interface. This force can slightly (adjustable) push the variations which the designer induces with the controller in a certain direction that is desirable from a functional perspective and that has been derived from the original shape and the shapes calculated in the optimization process P1. Furthermore, design variations in functionally undesirable directions can be made more difficult by increasing the resistance of the controller in that direction.

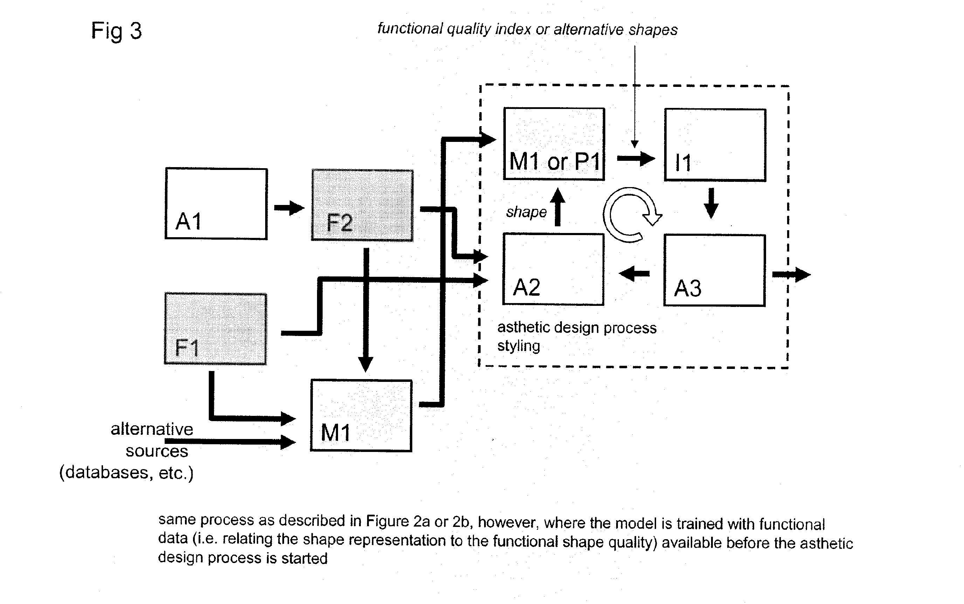

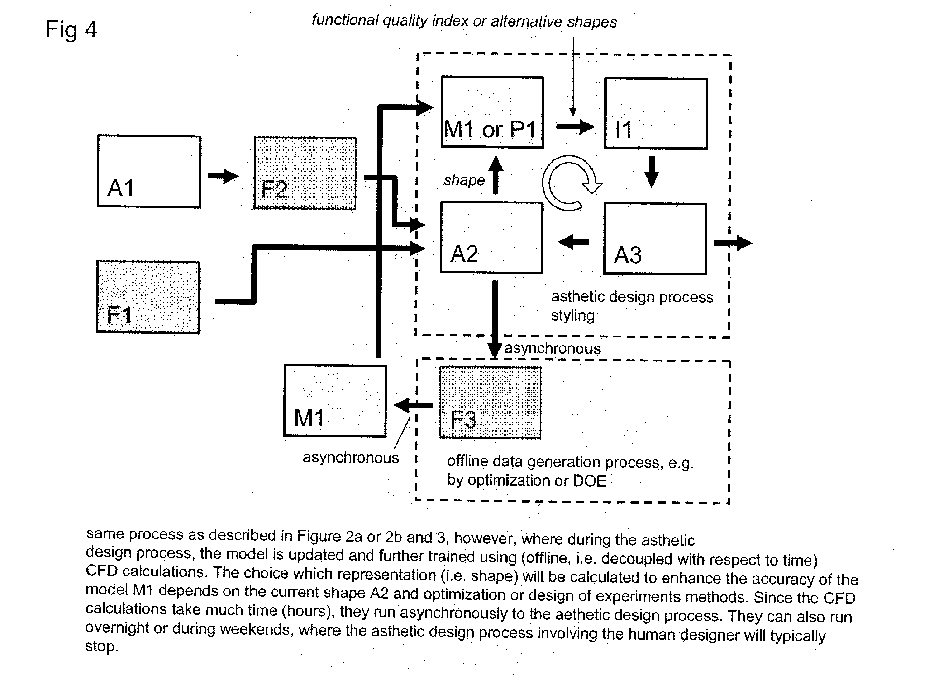

Figures 3 and 4 describe additional ways how the model M1 (or models if an ensemble of models is being used) can be improved using data available before the aesthetic design process starts (Figure 3) or data that is generated during the aesthetic design process (Figure 4). In the later case, it is important that both processes are run asynchronously. In general, the aesthetic design process will change the shapes (denoted by A2 and A3 in the figures) much faster than the CFD calculation (one needs several hours), so the "aesthetic design loop" has to proceed while the CFD calculation runs. At the same time, during the night or during weekend or due to other constraints, the aesthetic design process will stop and several CFD calculations might be possible using design of experiments methods or optimization methods. This information will then be fed back to the model M1.

### Application Areas

The invention may find application in the design of any real-world object, but especially in the following fields: Automotive design, motorcycle design, aeronautic design, boat design, furniture design, industrial design.

### Glossary

**CAD** - computer aided design
**CAE** - computer aided engineering
**CFD** - computational fluid dynamics
**Aesthetic design** - a process involving a designer where an object is shaped according to the artistic taste of the designer and/or according to some brand specifics (e.g. automotive design, furniture design)
**Functional design** - a process where an object is shaped according to some objective physical quality measures provided by experiments (including computer experiments), e.g. minimization of drag, maximization of thermal resistance, maximization of crash resistance.
**Aesthetic representation** - a parametric description of an object that is most suitable for variations invoked by a human designer during the aesthetic design process, e.g. CAD data or digital clay data
**Functional representation** - a parametric description of an object that is most suitable for determining the physical quality measures of the object and/or for variations invoked by a computer program during an optimization process, e.g. free form deformation [8] or NURBS [7].
**Model representation** - a parametric description of an object that is most suitable for determining the physical quality measures of the object based on a specific model (e.g. a neural network). Often such a representation is a lower dimensional version of a functional representation.

### Prior Art references

[1] P. O'B Holt, J. M Ritchie, P. N. Day, J. E. L. Simmons, G. Robinson, G. T. Russell, and F. M. Ng. Immersive Virtual Reality In Cable and Pipe Routing: Design Metaphors and Cognitive Ergonomics. ASME Journal of Computing and Information Science in Engineering, 4(3), 161-170, 2004.
[2] SensAble Technologies. 3D Touch-enabled Modeling for Product Design, Digital Content Creation (DCC) & Fine Arts. http://www.sensable.com/industries-design-model.htm
[3] Douglas C. Montgomery. Design and Analysis of Experiments. Wiley & Sons, 7th edition, 2009.
[4] Yaochu Jin, Markus Olhofer and Bernhard Sendhoff. A Framework for Evolutionary Optimisation with Approximate Fitness Functions. IEEE Transactions on Evolutionary Computation, 6(5), pages 481-494, 2002.
[5] EP 1205877 A1 "Approximate fitness functions" of Honda Research Institute Europe GmbH
[6] EP 1557788 A1 "Reduction of fitness evaluations using clustering technique and neural network ensembles" of Honda Research Institute Europe GmbH
[7] Les Piegl and Wayne Tiller. The NURBS book. Springer, 1996.
[8] Stefan Menzel and Bernhard Sendhoff. Representing the change - free form deformation for evolutionary design optimization. In T. Yu, L. Davis, C. Baydar and R. Roy (Eds.) Evolutionary Computation in Practice, 63-86, 2008.
[9] Lars Graening, Stefan Menzel, Martina Hasenjager, Thomas Bihrer, Markus Olhofer and Bernhard Sendhoff. Knowledge Extraction from Aerodynamic Design Data and its Application to 3D Turbine Blade Geometries. In Journal of Mathematical Modelling and Algorithms, 7(4), 329-350, 2008.

## Claims

1. A method for integrating aesthetic and functional computerized design processes for real-world objects,
the method comprising the following steps:
a.) defining an aesthetic representation of a real-world object,
b.) using an approximation model of a CAE simulation to calculate functional quality value(s) using the parametric description of the aesthetic representation as input,
c.) issuing a physical signal to a user, the physical signal communicating the quality value(s) to the user,
d.) automated changing, upon input from a user interface, the parametric description of the aesthetic representation of the object in the aesthetic design process taking the obtained functional quality value into account, and
e.) repeating steps b.) to d.) until a termination criterion is met.

2. A method for integrating aesthetic and functional computerized design processes for real-world objects,
the method comprising the following steps:
a.) defining an aesthetic representation of a real-world object,
b.) using an approximation model of a CAE simulation to calculate functional quality value(s) using the parametric description of the aesthetic representation as input,
c.) changing the parametric description of the aesthetic representation and deriving the quality values using the approximation model for these design variations in order to perform a sensitivity analysis of the quality values for a set of design variations,
c.) issuing a physical signal to a user, the physical signal communicating the sensitivity of the quality values for different changes of the parametric description of the aesthetic representation of the design to the user,
d.) automated changing, upon input from a user interface, the parametric description of the aesthetic representation of the object in the aesthetic design process taking the obtained sensitivity analysis into account,
e.) repeating steps b.) to d.) until a termination criterion is met.

3. The method according to the claim 1 and 2, wherein a transformation is included from the aesthetic representation to the model representation and where the approximation model receives the parametric description of the model representation of the object as input.

4. A method for integrating aesthetic and functional computerized design processes for real-world objects,
the method comprising the following steps:
a.) defining an aesthetic representation of a real-world object,
b.) defining a transformation of the aesthetic representation of the object to a functional representation,
b.) using an approximation model of a CAE simulation to calculate functional quality value(s) using the parametric description of the functional representation as input,
c.) running an optimization process in order to produce at least one modified design with improved quality values using the approximation model of a CAE simulation as a cost function during the optimization process,
d.) issuing a physical signal to a user, the physical signal communicating to a user as how to modify the design in order to achieve an improved quality value,
e.) automated changing, upon input from a user interface, the parametric description of the aesthetic representation of the object in the aesthetic design process taking the result of the optimization process into account, and
f.) repeating steps c.) to d.) until a termination criterion is met.

5. The method according to the claim 2 and 4,
wherein a transformation is included from the functional representation to the model representation and where the approximation model receives the parametric description of the model representation of the object as input.

6. The method according to any of the preceding claims,
wherein a transformation is included from the functional representation to the aesthetic representation in order to derive the most suitable physical signal to be communicated back to the user in step 2d.

7. The method according to any of the preceding claims, comprising the additional step f.) of building the real world object based on the aesthetic or functional representation present when the termination criterion has been met.

8. The method according to any of the preceding claims,
wherein the initial aesthetic representation of the design is based on CAD data.

9. The method according to any of the preceding claims,
wherein the functional representation of the design is based on a free form deformation.

10. The method according to any of the preceding claims,
wherein the functional representation of the design is based on a NURBS representation

11. The method according to any of the preceding claims,
wherein the physical signal is a visual indication and/or a haptic feedback.

12. The method according to any of the preceding claims,
wherein the approximation model is derived using apriori available data relating the parametric description of the model representation and/or the functional representation and/or the aesthetic representation to the functional quality value(s) of the design

13. The method according to any of the preceding claims,
wherein the approximation model is updated or newly derived during the integrated design process by using data generated asynchronously from CAE simulations

14. The method according to any of the preceding claims,
wherein the approximation model is a neural network.

15. The method according to any of the preceding claims, wherein the approximation model is a Kriging (Gaussian) model.

16. The method according to any of the preceding claims,
wherein the optimization is carried out with an evolution strategy.

17. A computer software program product, implementing a method according to any of the preceding claims when run on a computing device.

18. Use of a method according to any of claims 1 to 16 for designing automobiles, motorbikes or aeronautic vehicles.

19. A computer-assisted system for integrating aesthetic and functional design processes for real-world objects,
the system comprising:
a.) a computerized module for defining an aesthetic representation of a real-world object,
b.) a computing module supplied with approximation model data of a CAE simulation module to calculate functional quality value(s) using a parametric description of the aesthetic representation as input,
c.) an interface for issuing a physical signal to a user, the physical signal communicating the quality value(s) to the user, and
d.) a computerized module for changing, upon input from a user interface, the parametric description of the aesthetic representation of the object in the aesthetic design process taking the obtained functional quality value into account.

20. A computer-assisted system for integrating aesthetic and functional design processes for real-world objects,
the system comprising:
a.) a computerized module for enabling a user to define an aesthetic representation of a real-world object,
b.) a computing module supplied with approximation model data of a CAE simulation module to calculate functional quality value(s) using a parametric description of the functional representation as input,
c.) a module for changing the parametric description of the aesthetic representation and for deriving the quality values using the approximation model for these design variations in order to perform a sensitivity analysis of the quality values for a set of design variations,
c.) an interface for issuing a physical signal to a user, the physical signal communicating the sensitivity of the quality values for different changes of the parametric description of the aesthetic representation of the design to the user, and
d.) a computerized module for changing, upon input from a user interface, the parametric description of the aesthetic representation of the object in the aesthetic design process taking the obtained sensitivity analysis into account.

21. A computer-assisted system for integrating aesthetic and functional design processes for real-world objects,
the system comprising:
a.) a computerized module for enabling a user to define an aesthetic representation of a real-world object,
b.) a computerized module for defining a transformation of the aesthetic representation of the object to a functional representation,
b.) a computing module supplied with approximation model data of a CAE simulation module to calculate functional quality value(s) using a parametric description of the functional representation as input,
c.) an optimization module producing at least one modified design with improved quality values using the approximation model of the CAE simulation module as a cost function during the optimization process,
d.) an interface for issuing a physical signal to a user, the physical signal communicating to a user as how to modify the design in order to achieve an improved quality value, and
e.) a computerized module for changing, upon input from a user interface, the parametric description of the aesthetic representation of the object in the aesthetic design process taking the result of the optimization process into account.

## Amended claims

### Amended claims in accordance with Rule 137(2) EPC.

**1.** A method for integrating aesthetic and functional computerized design processes for physical objects, the method comprising the following steps:
a) defining an aesthetic representation of a physical object,
b) defining a transformation of the aesthetic representation of the object to a functional representation,
c) using an approximation model of a CAE simulation to calculate functional quality value(s) using a parametric description of the functional representation as input,
d) issuing a physical signal to a user, the physical signal communicating the quality value(s) to the user,
e) automated changing, upon input from a user interface, the parametric description of the aesthetic representation of the object in the aesthetic design process taking the obtained functional quality value into account, and
f) repeating steps b) to d) until a termination criterion is met.

**2.** The method of claim 1 comprising at least one of the following steps:
- using an approximation model of a CAE simulation to calculate functional quality value(s) using the parametric description of the aesthetic representation as input,
- changing the parametric description of the aesthetic representation and deriving the quality values using the approximation model for these design variations in order to perform a sensitivity analysis of the quality values for a set of design variations,
- issuing a physical signal to a user, the physical signal communicating the sensitivity of the quality values for different changes of the parametric description of the aesthetic representation of the design to the user,
- automated changing, upon input from a user interface, the parametric description of the aesthetic representation of the object in the aesthetic design process taking the obtained sensitivity analysis into account,

**3.** The method according to the claim 1 or 2,
wherein a transformation is included from the aesthetic representation to the model representation and where the approximation model receives the parametric description of the model representation of the object as input.

**4.** The method of any of the preceding claims comprising at least one of the following steps:
- running an optimization process in order to produce at least one modified design with improved quality values using the approximation model of a CAE simulation as a cost function during the optimization process,
- issuing a physical signal to a user, the physical signal communicating to a user as how to modify the design in order to achieve an improved quality value,
- automated changing, upon input from a user interface, the parametric description of the aesthetic representation of the object in the aesthetic design process taking the result of the optimization process into account, and

**5.** The method according to any of the preceding claims, wherein a transformation is included from the functional representation to the model representation and where the approximation model receives the parametric description of the model representation of the object as input.

**6.** The method according to any of the preceding claims, wherein a transformation is included from the functional representation to the aesthetic representation in order to derive the most suitable physical signal to be communicated back to the user in step e) of claim 1.

**7.** The method according to any of the preceding claims, comprising the additional step
- of building the real world object based on the aesthetic or functional representation present when the termination criterion has been met.

**8.** The method according to any of the preceding claims, wherein the initial aesthetic representation of the design is based on CAD data.

**9.** The method according to any of the preceding claims, wherein the functional representation of the design is based on a free form deformation.

**10.** The method according to any of the preceding claims,
wherein the functional representation of the design is based on a NURBS representation

**11.** The method according to any of the preceding claims,
wherein the physical signal is a visual indication and/or a haptic feedback.

**12.** The method according to any of the preceding claims,
wherein the approximation model is derived using apriori available data relating the parametric description of the model representation and/or the functional representation and/or the aesthetic representation to the functional quality value(s) of the design

**13.** The method according to any of the preceding claims,
wherein the approximation model is updated or newly derived during the integrated design process by using data generated asynchronously from CAE simulations

**14.** The method according to any of the preceding claims,
wherein the approximation model is a neural network.

**15.** The method according to any of the preceding claims, wherein the approximation model is a Kriging (Gaussian) model.

**16.** The method according to any of the preceding claims,
wherein the optimization is carried out with an evolution strategy.

**17.** A computer software program product, implementing a method according to any of the preceding claims when run on a computing device.

**18.** Use of a method according to any of claims 1 to 17 for designing automobiles, motorbikes or aeronautic vehicles.

**19.** A computer-assisted system for integrating aesthetic and functional design processes for physical objects,
the system comprising:
a) a computerized module for defining an aesthetic representation of a physical object,
b) a computerized module for defining a transformation of the aesthetic representation of the object to a functional representation,
c) a computing module supplied with approximation model data of a CAE simulation module to calculate functional quality value(s) using a parametric description of the functional representation as input,
d) an interface for issuing a physical signal to a user, the physical signal communicating the quality value(s) to the user, and
e) a computerized module for changing, upon input from a user interface, the parametric description of the aesthetic representation of the object in the aesthetic design process taking the obtained functional quality value into account.

**20.** The computer-assisted system for of claim 19, comprising:
- a module for changing the parametric description of the aesthetic representation and for deriving the quality values using the approximation model for these design variations in order to perform a sensitivity analysis of the quality values for a set of design variations,
- an interface for issuing a physical signal to a user, the physical signal communicating the sensitivity of the quality values for different changes of the parametric description of the aesthetic representation of the design to the user, and
- a computerized module for changing, upon input from a user interface, the parametric description of the aesthetic representation of the object in the aesthetic design process taking the obtained sensitivity analysis into account.

**21.** The computer-assisted system for of claim 19 or 20, comprising :
- an optimization module producing at least one modified design with improved quality values using the approximation model of the CAE simulation module as a cost function during the optimization process,
- an interface for issuing a physical signal to a user, the physical signal communicating to a user as how to modify the design in order to achieve an improved quality value, and
- a computerized module for changing, upon input from a user interface, the parametric description of the aesthetic representation of the object in the aesthetic design process taking the result of the optimization process into account.
